# FASCICULE DE BREVET EUROPEEN

(11) **EP 0 902 927 B1**
(45) Date de publication et mention de la délivrance du brevet: **12.01.2000**
(21) Numéro de dépôt: 97927240.8
(22) Date de dépôt: 05.06.1997
(51) Int. Cl.: G06K 19/077

(54) **CARTE A MEMOIRE ET PROCEDE DE FABRICATION D'UNE TELLE CARTE**
SPEICHERKARTE UND VERFAHREN ZU IHRER HERSTELLUNG
MEMORY CARD AND METHOD FOR PRODUCING SAME

(30) Priorité: 07.06.1996 FR 9607091
(43) Date de publication de la demande: 24.03.1999
(73) Titulaire: SCHLUMBERGER Systèmes, 92120 Montrouge (FR)
(72) Inventeur: BILLEBAUD, Pascal, F-45000 Orléans (FR)
(74) Mandataire: Jaunez, Xavier
(86) Numéro de dépôt international: FR9700995
(87) Numéro de publication internationale: WO9748074

(56) Documents cités:
- EP-A- 0 128 822
- EP-A- 0 189 039
- EP-A- 0 311 434
- EP-A- 0 331 316
- PATENT ABSTRACTS OF JAPAN vol. 10, no. 274 (P-498), 18 Septembre 1986 & JP 61 095486 A (HITACHI LTD), 14 Mai 1986,

## Description

L'invention concerne une carte à mémoire à circuit intégré, et plus particulièrement une carte à mémoire du type comportant un corps de carte dans une face duquel (ou plus précisément au travers d'une face duquel) est enchâssé un circuit intégré, avec sur cette face un motif conducteur constitué par une pluralité de plages conductrices et de lignes conductrices de lecture/écriture associées reliant ces plages au circuit intégré.

On pourra par exemple se référer aux documents FR-A-2.671.416 et FR-A-2.684.471 de la demanderesse, qui décrivent une carte à mémoire du type précité.

Ce type de carte à mémoire à circuit intégré enchâssé dans la masse du corps de carte manque parfois de fiabilité, du fait des contraintes exercées sur les bords du circuit intégré lorsque la carte est soumise à une flexion. Si cette flexion est importante, la courbure du corps de carte risque de déstabiliser l'implantation du circuit intégré dans le corps de carte, ce qui peut aller jusqu'à une expulsion dudit circuit intégré. Dans la pratique, il est courant de prévoir un recouvrement du motif conducteur, par exemple au moyen d'un vernis souvent transparent, en laissant dégagées les plages conductrices du motif conducteur. Cette épaisseur de protection participe au maintien du circuit intégré dans le corps de carte en cas de flexion dudit corps de carte, mais ce maintien reste d'efficacité limitée.

Il existe en conséquence un besoin d'améliorer l'implantation du circuit intégré dans le corps de carte afin d'obtenir une meilleure résistance aux flexions imprimées à la carte.

Ce problème technique était déjà connu dans le cas de cartes laminées, du type comportant une couche de coeur ramollissable à chaud, deux couches de recouvrement disposées de part et d'autre de la couche de coeur, et un module intégré à la couche de coeur et à l'une des couches de recouvrement par laminage à chaud après empilage des différents éléments constituant la carte. Pour des cartes de ce type, on a ainsi proposé de disposer une ceinture entourant le module s'étendant dans la couche de coeur, afin de limiter les efforts de flexion auxquels la masse de résine constituant le module est soumise, ce qui réduit en conséquence le risque de rupture des organes de liaison (on pourra en particulier se référer aux documents WO-A-91 01533 et EP-A-0 466 557).

Il n'est toutefois pas possible d'utiliser ces techniques dans le cas d'un circuit intégré directement enchâssé dans la masse du corps de carte, car la mise en place d'une ceinture autour du circuit intégré serait totalement impraticable.

Il a été par ailleurs proposé de disposer dans le fond du logement d'un corps de carte une plaquette de renfort qui sert à rigidifier la zone d'implantation du circuit intégré, comme cela est illustré dans le document JP-A-61 095486. Toutefois, le renforcement procuré est limité, car ni la plaquette de renfort, ni le circuit intégré ne sont enchâssés dans le corps de carte.

Le document EP-A-0 189 039 décrit une carte laminée dans laquelle le circuit intégré est logé dans un creux formé dans un noyau dur disposé dans la couche de coeur de la carte afin d'assurer une certaine protection du circuit intégré lorsque la carte subit des déformations.

Le document EP-A-0 311 434 décrit une carte laminée à circuit intégré, avec un élément de renfort en forme d'étoile disposé sur chacune des deux faces du corps de carte, de part et d'autre du circuit intégré.

Le document EP-A-0 331 316 décrit enfin une carte laminée dans laquelle le circuit intégré est entouré par un élément tubulaire déformable en caoutchouc servant à absorber les chocs et les déformations lorsque la carte est manipulée.

Le document EP-A-0 128 822 décrit par ailleurs un procédé de montage d'un module à circuit intégré dans un corps de carte par enfoncement à chaud. Il est à noter qu'aucun élément de renfort n'est prévu dans la zone du circuit intégré.

L'invention a pour but de résoudre le problème précité, en concevant une carte à mémoire du type à circuit intégré enchâssé dans le corps de carte, dont la structure permet d'améliorer la fiabilité de l'implantation du circuit intégré dans le corps de carte.

Ce problème est résolu selon l'invention, grâce à une carte à mémoire du type comportant un corps de carte dans une face duquel est directement enchâssé un circuit intégré, avec sur cette face un motif conducteur constitué par une pluralité de plages conductrices et de lignes conductrices associées reliant ces plages au circuit intégré, caractérisée en ce qu'un élément de renfort agencé sous la forme d'un anneau fermé est noyé dans la matière du corps de carte, en regard de la zone du circuit intégré, en s'étendant dans un plan sensiblement parallèle à la face précitée du corps de carte.

L'anneau fermé de renfort, dont la fonction est de rigidifier localement la zone de la carte qui porte le circuit intégré et les liaisons électriques, procure ainsi une rigidification locale du corps de carte qui permet de diminuer considérablement les contraintes dans la zone concernée au niveau de la surface du circuit intégré, augmentant ainsi la fiabilité des liaisons électriques.

De préférence, l'anneau fermé formant l'élément de renfort est disposé en regard des plages conductrices du motif conducteur. La zone rigidifiée s'étend ainsi au-delà de la zone qui est en regard des lignes conductrices, ce qui procure une fiabilité très satisfaisante pour les liaisons électriques.

De préférence, l'anneau fermé formant l'élément de renfort sera disposé sensiblement à mi-épaisseur dans le corps de carte.

Conformément à un mode d'exécution particulier, l'anneau fermé formant l'élément de renfort est de révolution autour d'un axe, et le circuit intégré est essentiellement centré sur cet axe. L'anneau de révolution pourra par ailleurs avoir une section de forme arrondie ou quadrangulaire : une telle section facilite l'enchâssement de l'anneau dans le corps de carte, en favorisant le fluage de la matière autour des parois latérales dudit anneau.

L'anneau fermé formant l'élément de renfort pourra être réalisé en tout matériau rigide convenable, et être un produit injecté en matière plastique rigide, par exemple un polyacrylique injectable ou un polyoxyméthylène homopolymère, ou un produit métallique, par exemple en acier ou en cuivre.

L'invention concerne également un procédé de fabrication d'une carte à mémoire présentant l'une au moins des caractéristiques précitées, ledit procédé étant remarquable en ce qu'il comporte les étapes successives suivantes :
a) on dispose un anneau fermé rigide sur une face supérieure d'une première feuille de matière plastique thermoplastique ;
b) on enfonce à chaud cet anneau rigide dans la première feuille;
c) on dispose une deuxième feuille de matière plastique thermoplastique sur la première feuille équipée de l'anneau rigide, et on assemble sous pression à chaud les première et deuxième feuilles de façon à constituer un ensemble dont l'épaisseur correspond à celle du corps de carte de la carte à réaliser;
d) on enfonce à chaud un circuit intégré dans la face supérieure libre de la deuxième feuille, jusqu'à enchâssement dudit circuit intégré, à un emplacement tel que l'anneau rigide soit en regard de la zone du circuit intégré;
e) on réalise de façon connue en soi sur cette face supérieure libre un motif conducteur à plages conductrices et lignes conductrices associées.

De préférence, l'étape b) d'enfoncement à chaud de l'anneau rigide est menée jusqu'à un enchâssement partiel dudit élément dans la première feuille, et l'étape c) réalise simultanément un enchâssement partiel de cet anneau rigide dans la deuxième feuille. On est ainsi assuré d'un ancrage très satisfaisant de l'anneau rigide dans la masse du corps de carte.

De préférence, les première et deuxième feuilles utilisées ont sensiblement la même épaisseur, de sorte que l'implantation de l'anneau rigide se situe sensiblement à mi-épaisseur dans le corps de carte, c'est-à-dire dans le plan médian (contenant la ligne neutre) dudit corps.

De préférence enfin, l'étape e) est suivie d'une étape f) connue en soi de recouvrement du motif conducteur par une couche de protection, en laissant apparentes les plages conductrices dudit motif.

D'autres caractéristiques et avantages de l'invention apparaîtront plus clairement à la lumière de la description qui va suivre, et des dessins annexés, concernant un mode de réalisation particulier, en référence aux figures où :
- la figure 1 est une vue schématique partielle de dessus d'une carte à mémoire conforme à l'invention, dans la zone de celle-ci qui comporte le circuit intégré, le corps de carte étant équipé d'un anneau de renfort noyé dans l'épaisseur du corps de carte ;
- la figure 2 est une coupe partielle selon II-II de la figure 1, permettant de mieux distinguer l'anneau de renfort disposé dans l'épaisseur du corps de carte;
- la figure 3 illustre les étapes successives, notées a) à f), d'un procédé de fabrication de la carte à mémoire précitée, conformément à un autre aspect de l'invention.

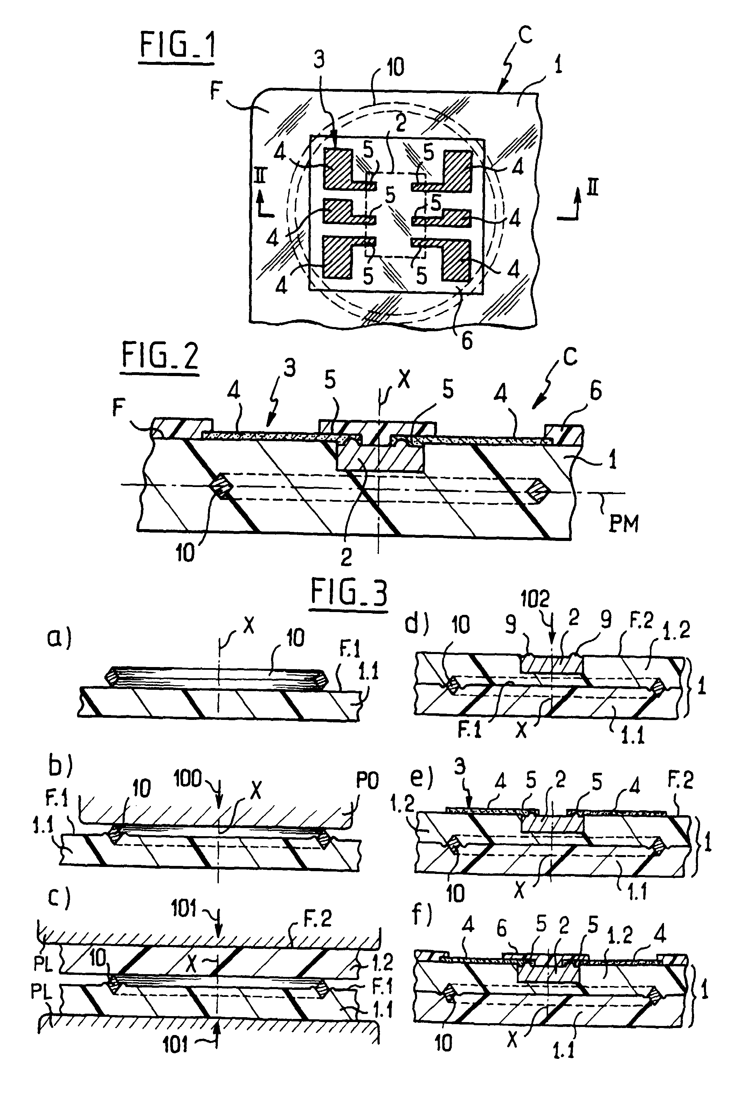

Les figures 1 et 2 illustrent une carte à mémoire C conforme à l'invention, ladite carte étant du type comportant un corps de carte 1 en matière isolante, par exemple en polycarbonate, dans une face (notée F) duquel est enchâssé un circuit intégré 2, avec sur cette face F un motif conducteur 3 constitué par une pluralité de plages conductrices 4 de lecture/écriture et de lignes conductrices associées 5 reliant ces plages au circuit intégré 2. En l'espèce, on a représenté un motif conducteur 3 constitué d'un ensemble de six plages conductrices 4, dont chacune est reliée au circuit intégré 2 par une ligne conductrice 5 associée. Toutefois, il va de soi qu'une telle représentation du motif conducteur 3 ne constitue qu'un exemple, l'invention ne devant en aucun cas être considérée comme limitée à un tel motif conducteur particulier.

Conformément à une caractéristique essentielle de l'invention, un élément de renfort 10 agencé sous la forme d'un anneau fermé est disposé dans l'épaisseur du corps de carte 1, en regard de la zone du circuit intégré 2, en s'étendant dans un plan noté (PM) sensiblement parallèle à la face précitée F du corps de carte 1. La zone concernée peut être la zone qui est directement en-dessous du circuit intégré 2 (la face F étant vue de dessus), mais on prévoira de préférence d'élargir cette zone jusqu'à inclure la zone qui est en-dessous des plages conductrices 4 du motif conducteur 3, de façon que la rigidification locale du corps de carte concerne l'ensemble des lignes conductrices du motif conducteur, afin d'obtenir une fiabilité optimale des liaisons électriques.

Sur la vue de dessus de la figure 1, on distingue ainsi un tel anneau de renfort 10 qui est en l'espèce de révolution autour d'un axe X, le circuit intégré 2 étant essentiellement centré sur cet axe X. Le diamètre intérieur de l'anneau 10 sera au moins égal à la plus grande dimension du circuit intégré, c'est-à-dire la diagonale dans le cas d'un circuit rectangulaire comme c'est le cas ici. Le diamètre extérieur dudit anneau correspondra de préférence à la plus grande dimension du contour renfermant les lignes conductrices du motif conducteur. Sur la figure 2, on constate que l'anneau fermé 10 est disposé sensiblement à mi-épaisseur dans le corps de carte 1, en s'étendant dans le plan PM. Ce plan PM est donc le plan médian du corps de carte 1, plan par lequel passe la ligne neutre parallèle à la direction longitudinale de la carte et servant de référence aux déformations dudit corps de carte en cas de flexion.

En l'espèce, l'anneau de révolution 10 présente une section de forme quadrangulaire, ici un losange à pointes tournées vers le haut et vers le bas. Un tel mode particulier d'exécution permet de faciliter l'implantation de l'anneau fermé 10 dans la masse du corps de carte, en favorisant le fluage de la matière plastique contre les parois latérales de l'anneau, ainsi que cela sera décrit plus en détail en référence à la figure 3 représentant les étapes du procédé de fabrication de cette carte à mémoire C. On pourra en variante prévoir une section de forme différente, notamment une section de forme arrondie.

L'anneau fermé 10 pourra être réalisé en tout matériau rigide conférant le renfort désiré de la zone du circuit intégré, et on pourra par exemple choisir une matière plastique telle qu'un polyacrylique injectable, (par exemple un polymétacrylate tel que le Plexiglas®) ou un polyoxyméthylène homopolymère (par exemple le polyacétal), ou encore un matériau métallique, tel que l'acier ou le cuivre.

On distingue également sur les figures 1 et 2 une couche de recouvrement 6, par exemple réalisée sous la forme d'un vernis de protection transparent, s'étendant en partie sur le motif conducteur 3, en laissant apparentes les plages conductrices 4 dudit motif. On a représenté sur la figure 1 un contour rectangulaire pour cette couche de protection 6, mais ceci ne constitue naturellement qu'un exemple particulier.

On va maintenant décrire, en référence à la figure 3, les différentes étapes successives d'un procédé de fabrication d'une carte à mémoire du type précédemment décrit. Les différentes étapes successives du procédé sont notées a) à f), les étapes caractéristiques étant les étapes a) à c) car elles concernent l'implantation de l'anneau rigide de renfort précité dans le corps de carte.

En a), on dispose un anneau fermé 10 rigide sur une face supérieure notée F.1 d'une première feuille 1.1 de matière plastique thermoplastique, l'axe X de l'anneau étant disposé en un point qui correspond au centre du circuit intégré qu'il est prévu d'implanter ultérieurement par enchâssement direct dans le corps de carte.

En b), un poinçon PO exerce une pression suffisante sur le bord supérieur de l'anneau rigide 10, et opère un enfoncement à chaud de cet anneau rigide dans la première feuille 1.1, le mouvement de descente du poinçon PO étant schématisé par la flèche 100. En l'espèce, cette étape b) d'enfoncement à chaud de l'anneau rigide 10 est menée jusqu'à enchâssement partiel (par exemple de moitié) dudit anneau dans la première feuille 1.1. On a représenté schématiquement des petits bourrelets de part et d'autre de la partie médiane de l'anneau rigide 10, représentant la matière thermoplastique repoussée par fluage contre les parois de l'anneau rigide lors de l'enfoncement à chaud dudit anneau.

En c), on dispose une deuxième feuille 1.2 de matière plastique thermoplastique sur la première feuille 1.1 équipée de l'anneau rigide 10, et on assemble sous pression à chaud les première et deuxième feuilles 1.1, 1.2 de façon à constituer un ensemble dont l'épaisseur correspond à celle du corps de carte de la carte à réaliser. En l'espèce, on a illustré un assemblage sous pression à chaud réalisé par compression entre deux plaques PL de presse, la plaque supérieure étant en appui contre la face supérieure notée F.2 de la deuxième feuille thermoplastique 1.2. Le serrage des plaques PL est schématisé par les flèches 101. Un tel collage sous pression à chaud peut être réalisé naturellement, par la fusion de la matière thermoplastique, sans qu'il soit nécessaire de prévoir une colle rapportée. En variante, on pourra réaliser cet assemblage sous pression à chaud en passant le sandwich constitué par les deux feuilles superposées entre deux rouleaux de laminage, conformément à une technique bien connue déjà utilisée pour réaliser des cartes à mémoire laminées du type rappelé plus haut. Le passage entre deux rouleaux permet d'effectuer un assemblage sous pression à chaud en continu, pour des feuilles thermoplastiques de grande longueur dans lesquelles il suffit ensuite de découper des corps de carte individuels. Les deux feuilles 1.1, 1.2 seront de préférence réalisées en une même matière thermoplastique, de façon que l'adhésion spontanée soit intime et fiable. On notera que l'adhésion des deux feuilles s'effectue au niveau du plan médian du corps de carte obtenu. Du fait de l'enchâssement partiel de l'anneau rigide 10 dans la première feuille 1.1 réalisé lors de l'étape b), l'étape c) réalise simultanément un enchâssement partiel de cet anneau rigide 10 dans la deuxième feuille 1.2. On est ainsi assuré d'un ancrage extrêmement fiable de l'anneau rigide 10, à un emplacement précisément déterminé.

Les étapes d), e), f) mises en oeuvre ensuite sont bien connues dans la technique concernée pour un corps de carte monobloc, et seront donc seulement brièvement rappelées ci-après.

En d) on enfonce à chaud un circuit intégré 2 dans la face supérieure libre F.2 de la deuxième feuille 1.2, jusqu'à enchâssement complet dudit circuit intégré, et ceci à un emplacement tel que l'anneau rigide 10 soit en regard de la zone du circuit intégré 2. Cet enfoncement est schématisé par la flèche 102. Comme cela est représenté, on s'assurera que le centre du circuit intégré 2 soit aussi précisément que possible calé sur l'axe X de l'anneau rigide 1O. On a noté 9 les plots du circuit intégré 2, lesquels plots sont tournés vers l'extérieur conformément à la technique classique d'enchâssement direct du circuit intégré dans le corps de carte.

En e), on réalise le motif conducteur 3 avec ses plages conductrices 4, et ses lignes conductrices associées 5 qui assurent la liaison des plages 4 aux plots du circuit intégré 2. Ceci est de préférence réalisé en déposant sur la face supérieure F.2 un polymère conducteur, notamment par une technique de sérigraphie.

En f), on réalise un recouvrement du motif conducteur 3 par une couche de protection 6, par exemple en vernis transparent, en laissant apparentes les plages conductrices 4 dudit motif.

On est ainsi parvenu à réaliser une carte à mémoire présentant localement une rigidité renforcée dans la zone qui porte le circuit intégré et les liaisons électriques. Cette rigidification permet de bien protéger les liaisons électriques en cas de flexion du corps de carte.

L'invention n'est pas limitée au mode de réalisation qui vient d'être décrit, mais englobe au contraire toute variante reprenant, avec des moyens équivalents, les caractéristiques essentielles énoncées plus haut.

## Revendications

1. Carte à mémoire, du type comportant un corps de carte (1) dans une face duquel est directement enchâssé un circuit intégré (2), avec sur cette face un motif conducteur (3) constitué par une pluralité de plages conductrices (4) et de lignes conductrices associées (5) reliant ces plages au circuit intégré (2), caractérisée en ce qu'un élément de renfort (10) agencé sous la forme d'un anneau fermé est noyé dans la matière du corps de carte (1), en regard de la zone du circuit intégré (2), en s'étendant dans un plan (PM) sensiblement parallèle à la face précitée du corps de carte (1).

2. Carte à mémoire selon la revendication 1, caractérisée en ce que l'anneau fermé (10) formant l'élément de renfort est disposé en regard des plages conductrices (4) du motif conducteur (3).

3. Carte à mémoire selon la revendication 1 ou la revendication 2, caractérisée en ce que l'anneau fermé (10) formant l'élément de renfort est disposé sensiblement à mi-épaisseur dans le corps de carte (1).

4. Carte à mémoire selon l'une des revendications 1 à 3, caractérisée en ce que l'anneau fermé (10) formant l'élément de renfort est de révolution autour d'un axe (X), et le circuit intégré (2) est essentiellement centré sur cet axe (X).

5. Carte à mémoire selon la revendication 4, caractérisée en ce que l'anneau de révolution (10) a une section de forme arrondie ou quadrangulaire.

6. Carte à mémoire selon l'une des revendications 1 à 5, caractérisée en ce que l'anneau fermé (10) formant l'élément de renfort est réalisé en matériau rigide, en étant un produit injecté en matière plastique rigide, par exemple un polyacrylique injectable ou un polyoxyméthylène homopolymère, ou un produit métallique, par exemple en acier ou en cuivre.

7. Procédé de fabrication d'une carte à mémoire (C) présentant l'une au moins des caractéristiques des revendications précédentes, caractérisé en ce qu'il comporte les étapes successives suivantes :
a) on dispose un anneau fermé rigide (10) sur une face supérieure (F.1) d'une première feuille (1.1) de matière plastique thermoplastique ;
b) on enfonce à chaud cet anneau rigide (10) dans la première feuille (1.1);
c) on dispose une deuxième feuille (1.2) de matière plastique thermoplastique sur la première feuille (1.1) équipée de l'anneau rigide (10), et on assemble sous pression à chaud les première et deuxième feuilles (1.1, 1.2) de façon à constituer un ensemble dont l'épaisseur correspond à celle du corps de carte de la carte à réaliser;
d) on enfonce à chaud un circuit intégré (2) dans la face supérieure libre (F.2) de la deuxième feuille (1.2), jusqu'à enchâssement dudit circuit intégré, à un emplacement tel que l'anneau rigide (10) soit en regard de la zone du circuit intégré (2);
e) on réalise de façon connue en soi sur cette face supérieure libre (F.2) un motif conducteur (3) à plages conductrices (4) et lignes conductrices associées (5).

8. Procédé selon la revendication 7, caractérisé en ce que l'étape b) d'enfoncement à chaud de l'anneau rigide (10) est menée jusqu'à un enchâssement partiel dudit anneau dans la première feuille (1.1), et l'étape c) réalise simultanément un enchâssement partiel de cet anneau rigide (10) dans la deuxième feuille (1.2).

9. Procédé selon la revendication 7 ou la revendication 8, caractérisé en ce que les première et deuxième feuilles (1.1, 1.2) utilisées ont sensiblement la même épaisseur.

10. Procédé selon l'une des revendications 7 à 9, caractérisé en ce que l'étape e) est suivie d'une étape f) connue en soi de recouvrement du motif conducteur (3) par une couche de protection (6), en laissant apparentes les plages conductrices (4) dudit motif.

## Patentansprüche

1. Speicherkarte mit einem Kartenkörper (1), in dessen eine Oberfläche ein integrierter Schaltkreis (2) direkt eingebettet ist, wobei diese Oberfläche ein Leitungsmuster (3) aufweist, das aus mehreren Kontaktflächen (4) und dazugehörigen Leiterbahnen (5) gebildet ist, die diese Bereiche mit dem integrierten Schaltkreis (2) verbinden, dadurch **gekennzeichnet**, daß ein Verstärkungselement (10) in Form eines geschlossenen Ringes in das Material des Kartenkörpers (1) gegenüber dem Bereich des integrierten Schaltkreises (2) eingebettet ist und sich auf einer Ebene (PM) erstreckt, die im wesentlichen parallel zur vorstehend genannten Oberfläche des Kartenkörpers (1) ist.

2. Speicherkarte nach Anspruch 1, dadurch **gekennzeichnet**, daß der das Verstärkungselement bildende geschlossene Ring (10) gegenüber den Kontakfflächen (4) des Leitungsmusters (3) angeordnet ist.

3. Speicherkarte nach Anspruch 1 oder 2, dadurch **gekennzeichnet**, daß der das Verstärkungselement bildende geschlossene Ring (10) - bezogen auf die Kartendicke - im wesentlichen mittig im Kartenkörper (1) angeordnet ist.

4. Speicherkarte nach einem der Ansprüche 1 bis 3, dadurch **gekennzeichnet**, daß der das Verstärkungselement bildende geschlossene Ring (10) ein Rotationskörper mit einer Achse (X) ist und der integrierte Schaltkreis (2) im wesentlichen zentrisch zu dieser Achse (X) angeordnet ist.

5. Speicherkarte nach Anspruch 4, dadurch **gekennzeichnet**, daß der Rotationsring (10) einen gerundeten oder viereckig geformten Querschnitt aufweist.

6. Speicherkarte nach einem der Ansprüche 1 bis 5, dadurch **gekennzeichnet**, daß der das Verstärkungselement bildende geschlossene Ring (10) aus steifem Material hergestellt ist, wobei dieses Material entweder aus hartem Kunststoff gespritzt wurde, wie beispielsweise aus spritzfähigem Polyacryl oder einem Polyoxymethylen Homopolymer, oder aber aus einem metallischen Material, wie beispielsweise Stahl oder Kupfer, besteht.

7. Verfahren zur Herstellung einer Speicherkarte (C), das zumindest eines der Merkmale der vorstehend genannten Ansprüche aufweist, dadurch **gekennzeichnet**, daß es folgende aufeinanderfolgende Schritte umfaßt:
a) ein geschlossener steifer Ring (10) wird auf einer Oberfläche (F.1) einer ersten Lage (1.1) aus thermoplastischem Kunststoffmaterial angebracht;
b) dieser steife Ring (10) wird unter Wärmeeinwirkung in die erste Lage (1.1) eingepreßt;
c) eine zweite Lage (1.2) aus thermoplastischem Kunststoffmaterial wird auf der ersten, mit dem steifen Ring (10) versehenen Lage (1.1), angebracht, und die erste und zweite Lage (1.1, 1.2) werden unter Druck und Wärmeeinwirkung derart zusammengesetzt, daß eine Einheit gebildet wird, deren Stärke der Stärke des Kartenkörpers der herzustellenden Karte entspricht;
d) unter Wärmeeinwirkung wird in die freie Oberfläche (F.2) der zweiten Lage (1.2) ein integrierter Schaltkreis (2) eingepreßt und derart eingelassen und angeordnet, daß der steife Ring (10) sich gegenüber dem Bereich des integrierten Schaltkreises (2) befindet;
e) auf an sich bekannte Weise wird so auf der freien Oberfläche (F.2) ein Leitungsmuster (3) mit Kontakfflächen (4) und dazugehörigen Leitern (5) hergestellt.

8. Verfahren nach Anspruch 7, dadurch **gekennzeichnet**, daß Schritt b), der das Einpressen des steifen Ringes (10) unter Wärmeeinwirkung beinhaltet, bis zu einem Punkt geführt wird, an dem der Ring teilweise in die erste Lage (1.1) eingelassen ist und Schritt c) gleichzeitig zu einer teilweisen Einbettung des steifen Ringes (10) in die zweite Lage (1.2) führt.

9. Verfahren nach Anspruch 7 oder 8, dadurch **gekennzeichnet**, daß die erste und die zweite Lage (1.1, 1.2) im wesentlichen dieselbe Stärke aufweisen.

10. Verfahren nach einem der Ansprüche 7 bis 9, dadurch **gekennzeichnet**, daß auf Schritt e) ein an sich bekannter Schritt f) folgt, in dem das Leitungsmuster (3) durch eine Schutzschicht (6) abgedeckt ist, während die Kontaktflächen (4) des Musters ausgespart werden.

## Claims

1. A memory card of the type comprising a card body (1) having a face in which an integrated circuit (2) is embedded directly, and having on said face a conductor pattern (3) constituted by a plurality of conductive areas (4) and of associated conductive tracks (5) connecting said areas to the integrated circuit (2), the card being characterized in that a reinforcing element (10) implemented in the form of a closed ring, is buried in the material of the card body (1) in register with the zone occupied by the integrated circuit (2), the ring extending in a plane (PM) to be substantially parallel to the above-specified face of the card body (1).

2. A memory card according to claim 1, characterized in that the closed ring (10) forming the reinforcing element is disposed in register with the conductive areas (4) of the conductor pattern (3).

3. A memory card according to claim 1 or claim 2, characterized in that the closed ring (10) forming the reinforcing element is disposed substantially at half-thickness within the card body (1).

4. A memory card according to any one of claims 1 to 3, characterized in that the closed ring (10) forming the reinforcing element is a body of revolution about an axis (X), and the integrated circuit (2) is essentially centered on said axis (X).

5. A memory card according to claim 4, characterized in that the circular ring (10) has a section that is rounded or that is quadrangular in shape.

6. A memory card according to any one of claims 1 to 5, characterized in that the closed ring (10) forming the reinforcing element is made of a rigid material, being made of an injected rigid plastics material, e.g. injectable polyacrylic or homopolymer polyoxymethylene, or a metal, e.g. steel or copper.

7. A method of fabricating a memory card (C) having at least one of the characteristics of the preceding claims, the method being characterized in that it comprises the following successive steps:
a) a rigid closed ring (10) is placed on a top face (F.1) of a first sheet (1.1) of thermoplastic plastics material;
b) said rigid ring (10) is pressed hot into the first sheet (1.1);
c) a second sheet (1.2) of thermoplastic plastics material is placed on the first sheet (1.1) fitted with the rigid ring (10), and the first and second sheets (1.1, 1.2) are assembled together by hot pressing so as to constitute an assembly of thickness corresponding to the card body thickness required for the card that is to be made;
d) an integrated circuit (2) is hot-pressed into the free top face (F.2) of the second sheet (1.2) until said integrated circuit is completely embedded therein, at a location such that the rigid ring (10) is in register with the zone occupied by the integrated circuit (2); and
e) a conductor pattern (3) having conducive areas (4) and associated conductive tracks (5) is made in conventional manner on said free top face (F.2).

8. A method according to claim 7, characterized in that step b) of hot-pressing the rigid ring (10) is continued until said ring is partially embedded in the first sheet (1.1), and step c) is performed simultaneously with said rigid ring (10) being simultaneously embedded in part in the second sheet (1.2).

9. A method according to claim 7 or claim 8, characterized in that the first and second sheets used (1.1, 1.2) are of substantially the same thickness.

10. A method according to any one of claims 7 to 9, characterized in that step e) is followed by a conventional step f) in which the conductor pattern (3) is covered by a protective layer (6) leaving uncovered the conductive areas (4) of said pattern.
